# EUROPEAN PATENT APPLICATION

(11) **EP 3 416 252 A1**
(43) Date of publication of application: **19.12.2018**
(21) Application number: 17305720.9
(22) Date of filing: 13.06.2017
(51) Int. Cl.: H01S 5/026, H01S 5/227, H01S 5/22, H01S 5/32

(54) **ONE STEP SIBH FOR INTEGRATED CIRCUITS**

(71) Applicant: Nokia Solutions and Networks Oy, 02610 Espoo (FI)
(72) Inventor: BARBET, Sophie, 91767 PALAISEAU (FR); DEBREGEAS, Hélène, 91767 PALAISEAU (FR)
(74) Representative: Novagraaf Technologies

(57) **Abstract**

The invention relates to a method for making a Semi-insulated Buried Heterostructure (10) on a substrate (20) on which an active area (40) and a doped cladding layer (50) are formed, comprising :
- depositing on the cladding layer (50) a dielectric mask comprising at least a first and a second section ;
- etching the cladding layer (50) and the active area (40) of both sections so as to obtain a waveguide (30) in each section ;
- removing the dielectric mask in a portion between the waveguides (30) of both sections ;
- etching the cladding layer;
- growing in the portion between the waveguides (30), a semiinsulating material (60) up to the level of the top of the cladding layer (40); and then
- removing the remaining dielectric mask.

The invention also relates to the obtained Semi-insulated Buried Heterostructure (10).

## Description

### Field of the Invention

The present invention relates to optoelectronic devices such as lasers and modulators. In particular, the invention relates to a method for making a Semi-insulated Buried Heterostructure (SiBH).

### Background

Semi-insulated Buried Heterostructure (SiBH) is a commonly used technology for optoelectronic devices, in particular for fast modulation components such as externally modulated lasers, semiconductor optical amplifiers, or more generally for photonic integrated circuits.

In such devices, a main issue is the electrical isolation between successive sections. While preparing such devices, H+ ion implantation is commonly used with success to achieve electrical isolation and suppress electrical conductivity of p-doped InP materials. However, in the case of semi-insolating InP, this process might damage the material and make it conductive.

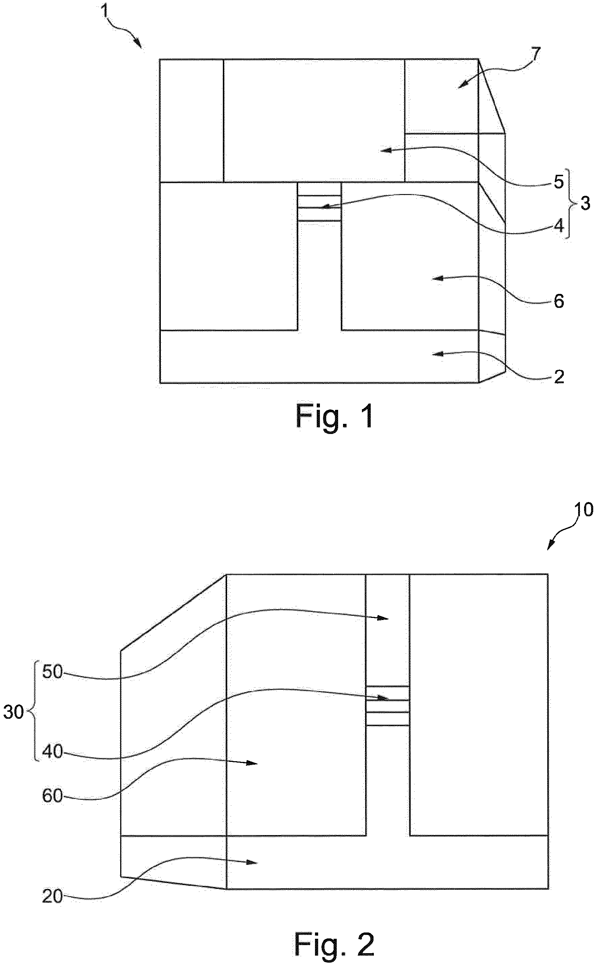

One solution to this issue, known from the state of the art, is to use a two-steps fabrication process, as illustrated in Figure 1.

In this approach, the semi-insulator material 6 is grown on the sides of the ridge waveguide 4 during a first regrowth, then p-doped InP 5 is grown over the whole surface during a second regrowth.

Electrical separation is obtained by H+ ion implantation on the top p-InP down to the active area.

However, such a two-steps process of realizing SiBH is a time consuming process and it requires ion implantation for electrical separation between electrodes, or for lateral electrical confinement.

Another existing solution is to use a long inter-electrodes section between two sections of the SiBH, such as a laser and a modulator, in order to reach sufficiently high electrical resistance. In this case, the resistance corresponds to p.S/L where p is the resistivity of p-doped InP, S is the section of p-doped InP (typically 2.5 x 1.5µm²), and L is the inter-electrodes length (100µm). But this solution has a large footprint, and generates additional propagation losses (in the order of 1 to 1.5dB) via absorption in the active material and in p-doped cladding layer.

The objective of the present invention is to provide a method for realizing SIBH that solves the problem of electrical isolation and that simplifies the fabrication process.

### Summary

In a first general embodiment, the invention relates to a method for making a Semi-insulated Buried Heterostructure on a substrate on which an active area and a doped cladding layer are formed, the method comprises the following steps of:
- depositing on the cladding layer a dielectric mask comprising at least a first and a second section, each of them including a first and a second waveguides ;
- etching the cladding layer and the active area of both sections so as to obtain a waveguide in each section and etching the cladding layer in a portion between the first and second section ;
- removing the dielectric mask in the portion between the waveguides of both sections ;
- etching the cladding layer in the portion between the waveguides of both sections ;
- growing in the portion between the waveguides, a semi-insulating material up to the level of the top of the cladding layer; and then
- removing the remaining dielectric mask.

In the method according to the invention, after the waveguide is defined, the doped cladding layer is etched in the portion between the first section and the second section. Then during the semi-insulating material regrowth, this area is covered by the semi-insulating material which thereby provides inter-electrode electrical isolation.

With this simplified process, ion implantation is no longer needed, and electrical isolation between the electrodes is obtained while the inter-electrode portion can be very short, ensuring thus low propagation losses and low footprint.

The active area is of the type known to the skilled person, and may include one active layer or a plurality of stacked layers.

In a second general embodiment, the invention relates to a Semi-insulated Buried Heterostructure including a first section comprising a first waveguide and second section comprising a second waveguide, the first and second waveguides including a cladding layer defining a first and a second electrode respectively, wherein the first and second electrodes are separated by a semi-insulating semiconductor material.

The waveguide of the first section may be a laser and the waveguide of the second section may be a modulator, or inversely.

Advantageously, the material of the substrate is n-doped InP.

Such substrate presents the advantage of being the standard material for telecommunication transmitters at 1.3 or 1.55 µm. In another embodiment, the material of the substrate may be semi-insulating InP, on which an n-doped buffer layer is grown.

Such configuration may be used to achieve very high modulation rates, that can reach 100 Gb / s.

Advantageously, the semi-insulating material is semi-insulating InP.
This presents the following advantages :
- In the laser section it makes it possible to force the current injection in the active area, containing for example Multi Quantum Wells (MQW) by blocking the lateral current more effectively than p-doped InP: the lateral diode p-InP / InP Semi-Insulating / n-InP is more blocking than an p-InP / n-InP diode.
- In the modulator section, it is possible to drastically reduce the lateral capacity. The thick lateral SIBH allows a very high thickness of MQW, therefore a very low lateral capacity, and thus it allows achieving high modulation rates.

If the lateral InP was p-doped, modulator capacity would be very high: this technology can only be applied to continuous or low-flow components.

The p-doped InP generates a large part of the optical losses (inter-band absorption of valence). To the contrary, the use of semi-insulating InP greatly reduces the confinement of the mode in the p-InP, thus reducing the optical losses. Advantageously, the cladding material is p-doped InP.

In the case of an n-doped InP substrate, the cladding material is preferably p-doped InP in order to allow injection of the electric current into the laser, or application of a voltage in the modulator.

According to another embodiment, the substrate is semi-insulating or p-doped InP, on which a p-doped InP layer is grown, and the cladding layer is n-doped InP.

In this case the amount of injection by the cladding layer is weak, and the n-doped InP is less resistive than the p-doped InP. This inversion can thus make it possible to reduce the access resistance.

### Brief Description of the Drawings

Some embodiments of the present invention are now described, by way of examples only, and with reference to the accompanying drawings, in which :
- The Figures 1 schematically illustrates a partial view of an SiBH according the state of the art;
- The Figures 2 schematically illustrates a partial view of an SiBH according to the present invention;
- The Figure 3A schematically illustrates a top view of an SiBH according to the invention.
- The Figures 3B and 3C schematically illustrate steps of SiBH fabrication according to the present invention.

### Description of Embodiments

Figure 1 shows partially an example of a Semi-insulating Buried Heterostructure (SiBH) 1 known from the state of the art.

In this example, the semi-insulator material 6 is grown on the sides of the ridge waveguide 4 during a first regrowth, then p-doped InP 5 is grown over the whole surface during a second regrowth.

Electrical insulated area 7 is obtained by H+ ion implantation of the top p-InP layer 5.

As already mentioned, this process of realizing SiBH is time consuming and it requires ion implantation for obtaining electrical separation between electrodes.

Figure 2 shows a first section of a Semi-insulated Buried Heterostructure 10 including said first section comprising a waveguide 30 and second section not shown, comprising a second waveguide. The waveguide 30 includes a cladding layer 50 defining a first electrical electrode on top of the active area 40.

The second section also includes a cladding layer on top of the active area which defines a second electrical electrode.

The first and second electrodes are separated by a semi-insulating semiconductor material 60, which contrary to the SiBH of the prior art does not require H+ ion implantation.

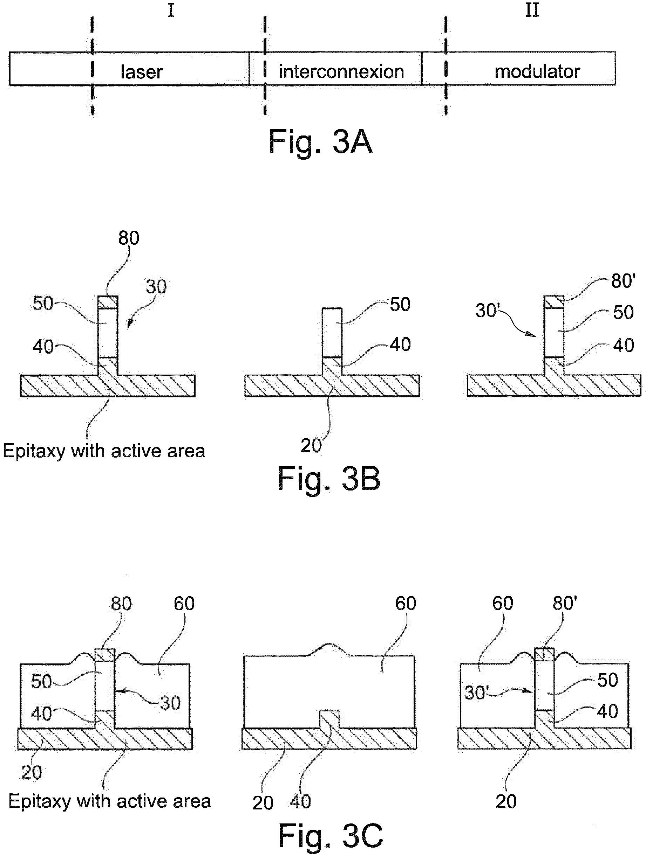

Figure 3A, is a schematic top view of an example of SiBH according to the invention wherein the first section I is a laser and the second section II is a modulator. The electrodes of both sections are separated by the semi-insulating semiconductor material 60.

Figures 3B and 3C schematically illustrate steps of fabrication of the SiBH of figure 3A.

Each of figure 3B and 3C present three vertical views, each of which correspond respectively to a projection of the laser section I, the interconnection region and the modulator section II, as indicated by the doted lines.

First, a substrate 20 is grown by epitaxy with an active area 40, on top of the substrate 20. Then a doped cladding layer 50, is grown on top of the active area 40.

In the next step, a dielectric mask is deposited on the cladding layer 50.

The dielectric mask includes including a first portion 80 in the first section I and a second portion 80' in the second section II, each of them including a waveguide 30, 30'. Both sections I, II are separated by the interconnection region wherein the dielectric mask includes a third portion which is not shown in the drawings.

Further, the cladding layer 50 and the active area 40 of both sections I, II are etched so as to obtain a waveguide 30, 30' in each section. The cladding layer 50 and the active area 40 are also etched in the interconnection portion between the first I and second II sections.

Figure 3B shows the next step wherein the third portion of dielectric mask has been removed. As this is shown, the first portion of the dielectric mask 80 is not removed on top of the waveguide 30 of the first section I, and the second portion of the dielectric mask 80' is not removed on top of the waveguide 30' of the second section II.

In the next step, the cladding layer 50 is etched in the interconnection portion between the waveguides 30, 30'. Then a semi-insulating material 60 is regrown up to the level of the top of the cladding layer 50, as this is shown by figure 3C.

Finally, the first and second portions 80, 80' of dielectric mask are removed.

As an example of application, the material of the substrate 20 may be n-doped InP, the semi-isolating material 60 may be semi-insulating InP and the material of the cladding layers 50 may be p-doped InP.

Compared to two-step SIBH with ion implantation, this process is much simpler with only one epitaxy regrowth to bury the waveguide, and no ion implantation. And in two-step SIBH, the parallel p / SI / n junction along the waveguide (typically 7µm on each side) generates a parasitic capacity (typically 50% of the central waveguide capacity) which is suppressed in one-step SIBH, leading to higher modulation bandwidths.

The description and drawings merely illustrate the principles of the invention. It will thus be appreciated that those skilled in the art will be able to devise various arrangements that, although not explicitly described or shown herein, embody the principles of the invention and are included within its spirit and scope.

More generally, the concept of the invention can be applied to components based on semiconductor materials of columns III-V, and to any compatible substrate. For example, this could be applied to components based on GaAs, or based on InP but on silicon substrate, for example hybrid by wafer bonding, or by direct growth when possible, as long as they are embedded components with the need to interrupt the electrical conductivity of the cladding layer.

Furthermore, all examples recited herein are principally intended expressly to be only for pedagogical purposes to aid the reader in understanding the principles of the invention and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A method for making a Semi-insulated Buried Heterostructure (10) on a substrate (20) on which an active area (40) and a doped cladding layer (50) are formed, the method comprises the following steps of:
- depositing on the cladding layer (50) a dielectric mask comprising at least a first (I) and a second (II) section, each of them including a first and a second waveguides (30, 30') ;
- etching the cladding layer (50) and the active area (40) of both sections (I, II) so as to obtain a waveguide (30, 30') in each section and etching the cladding layer (50) in a portion between the first and second section ;
- removing the dielectric mask in the portion between the waveguides (30, 30') of both sections (I, II);
- etching the cladding layer (50) in the portion between the waveguides (30, 30') of both sections (I, II);
- growing in the portion between the waveguides (30, 30'), a semi-insulating material (60) up to the level of the top of the cladding layer (50); and then
- Removing the remaining dielectric mask (80, 80').

2. The method according to claim 1, wherein the waveguide of the first section (I) is a laser and the waveguide of the second section (II) is a modulator.

3. The method according to anyone of claims 1 or 2, wherein the material of the substrate (20) is n doped InP.

4. The method according to anyone of claims 1 or 2, wherein the material of the substrate is semi-insulating InP on which an n doped InP buffer layer is grown.

5. The method according to anyone of claims 1 to 4, wherein the semi-insulating material (60) is semi-insulating InP.

6. The method according to anyone of claims 1 to 5, wherein the cladding material (50) is p doped InP.

7. A Semi-insulated Buried Heterostructure (10) including a first section (I) comprising a first waveguide (30) and second section (II) comprising a second waveguide (30'), the first and second waveguides including active areas (40) and cladding layers (50) defining a first and a second electrode respectively, the first and second electrodes being separated by a semi-insulating semiconductor material (60).

8. The Semi-insulated Buried Heterostructure (10) according to claim 7, obtained by anyone of claims 1 to 6.
